Europäisches Patentamt

European Patent Office

Office européen des brevets

(11) Publication number: **0 113 820**
**B1**

(12) **EUROPEAN PATENT SPECIFICATION**

(45) Date of publication of patent specification: **09.09.87**

(21) Application number: **83110963.2**

(22) Date of filing: **03.11.83**

(51) Int. Cl.⁴: **H 05 K 7/06**

(54) **Method and apparatus for embedding wire in a photocurable adhesive.**

(30) Priority: **22.12.82 US 452161**

(43) Date of publication of application:
**25.07.84 Bulletin 84/30**

(45) Publication of the grant of the patent:
**09.09.87 Bulletin 87/37**

(84) Designated Contracting States:
**DE FR GB**

(56) References cited:
**US-A-3 674 914**

(73) Proprietor: **International Business Machines
Corporation
Old Orchard Road
Armonk, N.Y. 10504 (US)**

(72) Inventor: **Jones, Philip Gordan
Rd3 Box 310
Towanda Pennsylvania 18848 (US)**
Inventor: **Skarvinko, Eugene Roman
4 Giles Street
Binghamton, N.Y. 13905 (US)**

(74) Representative: **Kindermann, Manfred
Schönaicher Strasse 220
D-7030 Böblingen (DE)**

## Description

This invention relates to a method and apparatus for embedding wire in an adhesive layer on a laminate sheet used in the manufacture of circuit boards.

Encapsulated wire circuit boards are typically fabricated by embedding wires in a layer of adhesive on a sheet of laminate material. Depending on the particular circuit board desired, the wires may be embedded on one or both sides of the laminate sheet. If a multilayer circuit board is desired, then several sheets of laminate material containing wires embedded thereon may be bonded together.

Conventional methods of manufacturing such boards involve the steps of: coating a layer of adhesive on the laminate sheet; heating the adhesive layer, typically ultrasonic energy is used; laying the wires on the sheet according to some predetermined pattern; and finally, curing the adhesive so as to permanently embed the wires in the adhesive layer on the laminate sheet. Circuit boards manufactured by the encapsulated wire circuit board technology and apparatus for manufacturing such boards are commercially available under the trade name "Multiwire" from Kollmargen Corp., USA.

In one of such methods the wires strand may be written and adherently affixed to the surface in curved paths (USA—Patent 3 674 914). Adherence of the wire image pattern to the surface of a base layer may be achieved by various means including mechanical and chemical adhering or bonding means, such as an adhesive coating activated chemically or pressure as well as radiation energy in form of heat, light or sound. After all of the wire patterns have been applied, they are pressed into the base surface or adhesive coating thereon, and the surface or coating is cured.

A problem that arises is that the wires tend to move in the adhesive from the time they are laid on the sheet until the time that the adhesive is cured. As a result, wire connections between layers on a multilayer circuit board or even those on a single layered board may not be made. This necessitates repairing the board and in some cases scrapping the board altogether. The wire connection problem has been observed in low density wired boards as well as high density wired boards.

It is desirable to eliminate this movement in the wires so that a functionally operable circuit board may be fabricated. This may be accomplished by either partially curing or totally curing the adhesive around a given wire as the wire is being laid in the adhesive on the laminate sheet. It is essential to cure the adhesive around the wire as it is being laid in order to stabilize the wire position. Even delaying the curing of the adhesive until the entire length of a single wire is laid results in wire movement.

Two other problems arise as a result of the curing apparatus that is typically used. Conventional curing apparatus consists of an ultraviolet oven. A laminate sheet containing wire in an adhesive layer is passed through the oven on a wire link conveyor belt. Due to the elevated temperatures in the oven, there is a tendency for wire movement. Additionally, the conveyor belt will cause undesirable indentations on a board having adhesive on both sides as the underside adhesive heats up and becomes malleable. The elimination of heat in the curing oven, which would solve these two problems, would be most beneficial.

Accordingly, it is an object of this invention to provide an improved method and apparatus for fabricating an encapsulated wire circuit board.

It is another object of this invention to provide a method and apparatus for ensuring that wires laid in a layer of adhesive on a laminate sheet maintain their original position.

It is still another object of this invention to provide a method and apparatus for selectively curing the adhesive around a given wire as the wire is laid in a layer of adhesive on a laminate sheet.

It is also an object of this invention to provide a method and apparatus for embedding wire in an adhesive wherein a heat generating curing oven is eliminated.

This invention, as claimed, achieves the above objects by providing a method and apparatus for embedding wires in a photocurable adhesive on a laminate sheet wherein the position integrity of the wires is maintained. In principle, wire is laid in a predetermined pattern in a layer of uncured malleable photocurable adhesive. As the wire is being laid, the photocurable adhesive surrounding the just laid wire is either partially cured or totally cured. In this manner, the wire is fixed in place and unable to move out of its predetermined position.

The uncured layer of photocurable adhesive may be heated and thus softened, prior to wire laying, by using either ultrasonic energy, optical energy, or some combination of the two. Additionally, the entire layer of the photo curable adhesive may be heated at the same time or selected areas on the layer may be heated as the wire is being laid.

A beam of ultraviolet radiation from a laser is used to cure the photocurable adhesive. A fiber optic cable may be connected to the laser in order to provide greater control over the directionality of the laser beam.

In an optional two step curing process, the photocurable adhesive is only partially cured as the wires are laid on the laminate sheet. This partial curing keeps the wires in the position that they were laid in. After all of the wires have been laid on a sheet, the sheet is then placed in an apparatus which scans an ultraviolet beam across the entire sheet. In this manner, the photocurable adhesive is totally cured and the wires are permanently fixed on the laminate sheet. This two step curing process would typically be used to prevent cracking of the adhesive when a multitude of wires are to be laid and/or when wire cross-overs are required.

An embodiment of this invention together with two methods is described in the following, referring to the appended drawing, in which:

Fig. 1 shows the apparatus used to lay wire in the adhesive on the laminate sheet and to either partially cure the adhesive in a two step process or to fully cure the adhesive in a one step process.

Fig. 2 shows the apparatus used to totally cure the adhesive on the laminate sheet in a two step curing process.

Figs. 3 and 4 show a top and a side view, respectively, of a portion of an encapsulated wire circuit board which may be produced by the apparatus and method of the present invention.

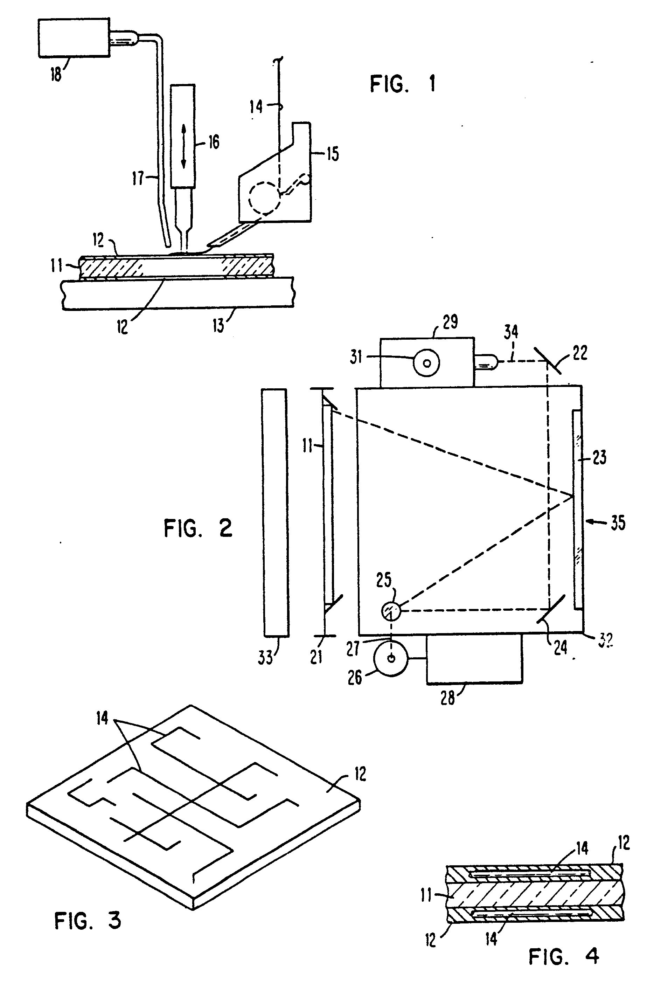

Referring now to Fig. 1, a laminate sheet 11 is clamped onto movable base 13. Laminate sheet 11 is typically constructed of a fiber glass type material. A layer of photocurable adhesive 12 is placed on the surface of laminate sheet 11. Although Figs. 1 and 4 show a layer of adhesive 12 on both sides of laminate sheet 11, the layer of photocurable adhesive 12 may be placed on just one side of laminate sheet 11. The layer of photocurable adhesive 12 is typically in sheet form having a thickness of 0,127—0,254 mm (5—10 mils) with plastic wrapping on both sides. To secure photocurable adhesive 12 to laminate sheet 11, the wrapping from one side of photocurable adhesive 12 is first removed. Adhesive 12 is then placed wrapper-less side down onto laminate sheet 11 and hot-pressed thereto. The wrapping on the other side is not removed until it is desired to lay wire 14 on laminate sheet 11.

After the photocurable adhesive 12 has been hot-pressed onto laminate sheet 11 and the plastic wrapping removed, wire may be laid according to the desired pattern. Wire 14 is fed from a wheel (not shown) and set into photo-curable adhesive 12 using machine head 15 and stylus 16. Machine head 15 guides wire 14 over the desired pattern. Machine head 15 may be automatically controlled, such as, for example, by a microprocessor controller. An example of a wiring pattern is shown in Fig. 3.

Stylus 16 vibrates up and down very quickly as it pushes down on wire 14 as it is being laid out over the desired pattern. Stylus 16 serves two functions. First, the very quick up and down vibratory motion produces ultrasonic heating. This ultrasonic heating softens the adhesive layer 12 in the vicinity of the wire 14 being laid. The second function of stylus 16 is to push wire 14 down into the heated, softened layer of photocurable adhesive 12. Fig. 4 shows the position of wire 14 in adhesive layer 12.

It will be recognized that means other than stylus 16 with its ultrasonic heating may be used for pushing wire 14 down into adhesive 12. For example, an optical heating means for softening adhesive 12 in conjunction with a roller for pushing wire 14 down into photocurable adhesive 12 may be employed. Additionally, an optical heating means used in conjunction with stylus 16 can also be used. Finally, an optical source of energy for heating the entire sheet at once may be used either with a roller or with a vibrating stylus.

As wire 14 is being laid and pushed into photocurable adhesive 12, the area of the adhesive layer around and surrounding the wire is either partially or totally cured. Partially curing the photocurable adhesive in the immediate vicinity of the just laid wire so as to immobilize the wire is the preferred embodiment. Fiber optic cable 17 guides a beam of ultraviolet radiation from laser 18 onto the photocurable adhesive 12 around wire 14 as the wire is being laid. A xenon chloride laser (XeCl) operating at a wavelength of 360—370 nm may be used. By partially curing photocurable adhesive 12 around wire 14, the wire is maintained in the position in which it was laid. It has no opportunity to move around in the layer of photocurable adhesive 12.

Fiber optic cable 17, stylus 16, and machine head 15 are stationary with respect to one another. Their movement across laminate sheet 11, which is clamped to base 13, is at an approximate speed of 5,08 m/min (200 inches per minute). Head 15, stylus 16, and cable 17 are mounted on a bridge (not shown) which moves in one direction across the base 13 and which also rotates angularly with respect to the base 13. Base 13 moves in a direction orthogonal to the direction of motion of the bridge. Using the nomenclature associated with a Cartesian coordinate system, it can be said that the bridge moves in the X and θ directions, while the base moves in the Y direction. It will be recognized by those skilled in the art that the directions of movement of base and bridge may be reversed or that either one may be held fixed while the other moves in the X, Y and θ directions.

In the alternative embodiment of the invention, a one step curing process is used. The apparatus shown in Fig. 1 and the procedure described thus far is sufficient to carry out this alternative embodiment. The only changes required would be to slow the movement of the ultraviolet beam across the laminate sheet 11 and to increase the energy level of laser 18 so as to totally cure photocurable adhesive 12 in one pass.

As noted above, the preferred embodiment entails a two step curing process. The first, or partial curing step, has already been described. The second and final step will now be described in relation to Fig. 2.

After the desired wiring pattern has been laid out and the surrounding photocurable adhesive partially cured, the entire laminate sheet 11 is placed into laser curing apparatus 35. The laminate sheet 11 containing the wired pattern in the partially cured adhesive is secured to clamp member 21. A beam 34 of ultraviolet radiation from laser 29 is then scanned across the secured laminate sheet 11 so as to totally cure photocurable adhesive 12, thus permanently embedding the wired pattern into the adhesive layer on the laminate sheet 11.

The structure and operation of laser curing apparatus 35 will now be explained in more detail. Optical apparatus 32 contains precision optically flat mirrors 22, 24, 25, and 23. These mirrors are situated in optical apparatus 32 so as to reflect beam 34 from laser 29 onto laminate sheet 11. Disc-shaped mirror 25 is connected via shaft 27 to motor 26. Motor 26 controls the position of mirror 25 so that beam 34 may be scanned from the top of the laminate sheet to the bottom of the laminate sheet in predetermined increments. The width of beam 34 from laser 29 is on the order of 1,6 mm (1/16 inch). Depending on the length of sheet 11, mirror 25 is moved so that beam 34 is scanned over the entire length of sheet 11. Motor control means 28 is used to control the operation of motor 26. A microprocessor may be used, for example, as motor control means 28.

Beam 34 is moved from left to right across the width of sheet 11 with the aid of stepper motor 31 which is connected to laser 29. Beam 34 begins at the top left corner of laminate sheet 11. Stepper motor 31 steps laser 29 from left to right thus causing beam 34 to step across laminate sheet 11 from left to right. When beam 34 gets to the right hand edge of sheet 11, the stepper motor is reset to the far left position and mirror 25 rotates so as to move beam 34 a beam width — in this example, it is 1,6 mm (1/16 inch) — down the sheet 11. This step and rotate cycle continues until beam 34 has scanned across the entire laminate sheet 11. It must be emphasized that beam 34 does not scan individual wires on sheet 11 but rather scans across the entire sheet. If a pattern has been wired on both sides of laminate sheet 11, then the sheet must be turned over and the process completed for the opposite side. Beam absorber 33 functions as a safety device, shielding an operator of the apparatus from stray ultraviolet radiation.

## Claims

1. An apparatus for embedding wire (14) in a layer (12) of photocurable adhesive on a laminate sheet (11), comprising:
   wiring means (15) for laying a length of wire (14) in a softened layer (12) of said photocurable adhesive, and
   illuminating means (17) for directing a beam of radiation to said softened layer (12) of photocurable adhesive as said length of wire is being laid, whereby said softened layer (12) of photocurable adhesive containing said length of wire is cured.

2. Apparatus according to claim 1, further comprising: heating means (16) for softening said layer (12) of photocurable adhesive.

3. Apparatus according to claim 2, wherein said heating means (16) selectively softens one or more areas in said layer (12) of photocurable adhesive on said laminate sheet (11), and said beam directing means (17) selectively directs a beam of radiation to each softened area as a wire (14) is being laid, whereby each softened area is cured.

4. Apparatus according to one or more of the claims 1 to 3 comprising:
   curing means (35) for scanning a beam of radiation (34) across at least said partially cured areas of said photocurable adhesive containing said wire (14), whereby said wire is permanently fixed in said photocurable adhesive.

5. Apparatus according to one or more of the claims 1 to 4, wherein said heating (16) means comprises a source of optical energy or a source of ultrasonic energy, or both.

6. Apparatus according to one or both of claims 4 and 5, said curing means (35) comprising:
   clamping means for securing thereto said laminate sheet (11) containing said wires (14) in said partially cured layer (14) of photocurable adhesive,
   a source (29) of optical energy for producing said beam of radiation (34),
   optical means (22—25, 32) for directing said beam of radiation (34) from said source (29) onto said partially cured laminate sheet (11),
   motor means (26, 31) for scanning said beam of radiation (34) across said laminate sheet (11), and
   control means (28) connected to said optical means for controlling the scanning of said beam of radiation (34) across the entire laminate sheet (11) to permanently fix said wires (14) in said photocurable adhesive.

7. A method for embedding wire (14) in a layer (12) of photocurable adhesive, comprising the steps of:
   laying said wire in a softened layer (12) of said photocurable adhesive, and
   illuminating said softened layer (12) of photocurable adhesive around said wire (14) as said wire is being laid to cure said photocurable adhesive.

8. Method according to claim 7, additionally comprising the step of heating said layer (12) of photocurable adhesive prior to the step of laying said wire.

9. Method according to claim 7 or 8, comprising the steps of:
   partially curing said softened layer (12) of photocurable adhesive around said wire (14) as said wire is being laid, and
   permanently fixing said wire (14) in said photocurable adhesive by scanning a beam of radiation (34) across said photocurable adhesive.

10. Method according to one or more of the claims 7 to 9 for embedding a plurality of wires (14) in a photocurable adhesive on a laminate sheet (11) used in an encapsulated wire circuit board, said method comprising the steps of:
   selectively heating a plurality of areas in a layer (12) of said photocurable adhesive on said laminate sheet (11) to soften said areas, selectively laying one of said wires (14) in each of said softened areas, and
   selectively illuminating each of said softened areas around each of said wires (14) to cure said photocurable adhesive.

11. Method according to claim 10, additionally comprising the step of permanently fixing said wires (14) in said softened areas by scanning a beam of radiation (34) across said layer (12) of photocurable adhesive.

## Patentansprüche

1. Vorrichtung zum Einbetten von Draht (14) in eine Schicht (12) aus lichthärtbarem Haftmaterial auf einer Laminatplatte (11), enthaltend:

Verdrahtungsmittel (15) zum Einbringen eines Drahtstückes (14) in eine erweichte Schicht (12) des lichthärtbaren Haftmaterials, und

Beleuchtungsmittel (17) zur Ausrichtung eines Lichtstrahles auf die erweichte Schicht (12) des lichthärtbaren Haftmaterials, so wie das Drahtstück in diese eingelegt ist, wodurch die das Drahtstück enthaltende erweichte Schicht (12) gehärtet wird.

2. Vorrichtung nach Anspruch 1, weiterhin enthaltend:

Erwärmungsmittel (16) zum Erweichen der Schicht (12) aus lichthärtbarem Haftmaterial.

3. Vorrichtung nach Anspruch 2, worin die Erwärmungsmittel (16) einen oder mehrere Bereiche der Schicht (12) aus lichthärtbarem Haftmaterial auf der Laminatplatte (11) wahlweise erweichen, und worin die Strahl-Ausrichtmittel (17) einen Energiestrahl wahlweise auf jeden erweichten Bereich entsprechend dem darin liegenden Drahtstück richten, wodurch jeder dieser Bereiche gehärtet wird.

4. Vorrichtung nach einem oder mehreren der Ansprüche 1 bis 3, enthaltend:

Härtematerial (35) zum Führen eines Energiestrahls (34) über zumindest teilweise gehärtete Bereiche des den Draht (14) enthaltenden lichthärtbaren Haftmaterials, wodurch der Draht permanent im lichthärtbaren Haftmaterial fixiert wird.

5. Vorrichtung nach einem oder mehreren der Ansprüche 1 bis 4, worin die Erwärmungsmittel (16) eine Quelle optischer Energie oder eine Quelle von Ultraschallenergie oder beides enthalten.

6. Vorrichtung nach einem oder mehreren der Ansprüche 4 bis 5, wobei die Härtemittel (35) enthalten:

Befestigungsmittel zur Halterung der Laminatplatte (11) mit den Drähten (14) in der teilweise gehärteten Schicht (12) aus lichthärtbarem Haftmaterial,

eine Quelle (29) optischer Energie zur Erzeugung des Energiestrahls (34),

optische Mittel (22 bis 25, 32), um den Lichtstrahl (34) von der Quelle (29) auf die teilweise gehärtete Laminatplatte (11) zu richten,

Antriebsmittel (26, 31) zum Führen des Energiestrahls (34) über die Laminatplatte (11),

sowie Steuermittel (28), die mit den optischen Mitteln verbunden sind zur Steuerung des Energiestrahls (34) über die gesamte Laminatplatte (11), um die Drähte (14) permanent in dem lichthärtbaren Haftmittel zu fixieren.

7. Verfahren zum Einbetten von Draht (14) in eine Schicht (12) aus lichthärtbarem Haftmaterial, folgende Schritte umfassend:

Einbringen des Drahtes in eine erweichte Schicht (12) des lichthärtbaren Haftmittels, und Belichten der erweichten Schicht (12) aus lichthärtbarem Haftmaterial entsprechend dem darin liegenden Draht (14), um das lichthärtbare Haftmaterial zu härten.

8. Verfahren nach Anspruch 7, zusätzlich umfassend den Schritt zur Erwärmung der Schicht (12) aus lichthärtbarem Haftmaterial vor dem Einbringen des Drahtes.

9. Verfahren nach Anspruch 7 oder 8, umfassend folgende Schritte:

Teilhärten der enthärteten Schicht (12) aus lichthärtbarem Haftmaterial im Bereich des darin liegenden Drahtes (14), sowie dessen permanentes Fixieren im lichthärtbaren Haftmaterial durch das Bewegen eines Energiestrahls (34) über das lichthärtbare Haftmaterial.

10. Verfahren nach einem oder mehreren der Ansprüche 7 bis 9 zum Einbetten mehrerer Drähte (14) in einem lichthärtbaren Haftmaterial auf einer Laminatschicht (11) in einer abgekapselten verdrahteten Schaltungsplatte, wobei das Verfahren folgende Schritte umfaßt:

Selektives Erwärmen mehrerer Bereiche in einer Schicht (12) des lichthärtbaren Haftmaterials auf der Laminatschicht (11) zum Erweichen der Bereiche, selektives Einbringen eines Drahtes (14) in jedem dieser Bereiche, sowie

selektives Belichten der erweichten Bereiche in der Umgebung der Drähte (14), um das lichthärtbare Haftmaterial zu härten.

11. Verfahren nach Anspruch 10, zusätzlich umfassend den Schritt der permanenten Fixierung der Drähte (14) in den erweichten Bereichen durch das Abtasten der Schicht (12) aus lichthärtbarem Haftmaterial durch einen Energiestrahl (34).

## Revendications

1. Appareil pour noyer un fil (14) dans une couche (12) d'adhésif photodurcissable recouvrant une feuille stratifiée (11), comprenant:

un moyen (15) de câblage pour poser une longueur de fil (14) dans une couche amollie (12) d'adhésif photodurcissable, et

un moyen (17) d'éclairement pour diriger un faisceau de radiations sur cette couche amollie (12) d'adhésif photodurcissable au moment où cette longueur de fil est posée, de manière à durcir cette couche amollie (12) d'adhésif photodurcissable contenant la longueur de fil.

2. Appareil suivant la revendication 1, comprenant un outre:

un moyen (16) de chauffage pour amollir la couche (12) d'adhésif photodurcissable.

3. Appareil suivant la revendication 2, dans lequel ce moyen (16) de chauffage amollit sélectivement une ou plusieurs régions de la couche (12) d'adhésif photodurcissable recouvrant la feuille stratifiée (11), et le moyen (17) de direction du faisceau dirige sélectivement un faisceau de radiations sur chaque région amollie au moment où un fil (14) est posé, de sorte que chaque région amollie se durcit.

4. Appareil suivant l'une ou plusieurs des revendications 1 à 3, comprenant:

un moyen (35) de durcissement pour envoyer un faisceau de radiations (34) de balayage en travers de ces régions partiellement durcies de l'adhésif photodurcissable contenant le fil (14), de sorte que ce dernier est fixé à demeure dans cet adhésif photodurcissable.

5. Appareil suivant l'une ou plusieurs des revendications 1 à 4, dans lequel le moyen (16) de chauffage comprend une source d'énergie optique ou une source d'énergie ultrasonore, ou les deux.

6. Appareil suivant l'une des deux ou suivant les deux revendications 4 et 5, ce moyen (35) de durcissement comprenant:

un moyen de serrage pour maintenir la feuille stratifiée (11) contenant les fils (14) noyés dans la couche (12) d'adhésif photodurcissable,

une source (29) d'énergie optique pour produire le faisceau (34) de radiations,

des moyens optiques (22 à 25, 32) pour diriger ce faisceau (34) de radiations de la source (29) sur la feuille stratifiée partiellement durcie (11), des moyens formant moteurs (26, 31) pour balayer la feuille stratifiée (11) par le faisceau (34) de radiations, et

un moyen (28) de commande relié aux moyens optiques pour commander le balayage de la totalité de la feuille stratifiée (11) par le faisceau (34) de radiations afin de fixer à demeure les fils (14) dans l'adhésif photodurcissable.

7. Procédé pour noyer un fil (14) dans une couche (12) d'adhésif photodurcissable, comprenant les stades de:

pose de ce fil dans une couche amollie (12) de cet adhésif photodurcissable, et

éclairement de cette couche amollie (12) d'adhésif photodurcissable autour de ce fil (14) au moment où ce fil est posé afin de durcir l'adhésif photodurcissable.

8. Procédé suivant la revendication 7, comprenant en outre le stade de chauffage de cette couche (12) d'adhésif photodurcissable préalablement au stade de pose du fil.

9. Procédé suivant l'une des revendications 7 ou 8, comprenant les stades de:

durcissement partiel de la couche amollie (12) d'adhésif photodurcissable autour du fil (14) au moment où ce fil est posé, et

fixation à demeure du fil (14) dans l'adhésif photodurcissable par balayage de ce dernier par un faisceau (34) de radiations.

10. Procédédé suivant l'une ou plusieurs des revendications 7 à 9, conçu pour noyer une pluralité de fils (14) dans un adhésif photodurcissable recouvrant une feuille stratifiée (11) utilisée dans une plaque pour circuit à fils encapsulés, ce procédé comprenant les stades de:

chauffage sélectif d'une pluralité de régions dans une couche (12) d'adhésif photodurcissable recouvrant la feuille stratifiée (11) afin d'amollir ces régions, pose sélective de l'un de ces fils (14) dans chacune de ces régions amollies, et éclairement sélectif de chacune de ces régions autour de chacun de ces fils (14) afin de durcir l'adhésif photodurcissable.

11. Procédé suivant la revendication 10, comprenant en outre le stade de fixation à demeure de ces fils (14) dans ces régions amollies par balayage de la couche (12) d'adhésif photodurcissable par un faisceau (34) de radiations.

FIG. 1

FIG. 2

FIG. 3

FIG. 4